# EUROPEAN PATENT APPLICATION

(11) **EP 1 003 196 A1**
(43) Date of publication of application: **24.05.2000**
(21) Application number: 99123043.4
(22) Date of filing: 19.11.1999
(51) Int. Cl.: H01J 1/30, C23C 16/56, C01B 31/06

(54) **Carbon material, method for manufacturing the same material, field-emission type cold cathode using the same material and method for manufacturing the same cathode**

(30) Priority: 19.11.1998 JP 34653898
(71) Applicant: NEC CORPORATION, Tokyo (JP)
(72) Inventor: Takemura, Hisashi, c/o NEC Coporation, Minato-ku, Tokyo (JP); Yamamoto, Hironori, Minato-ku, Tokyo (JP); Baba, Kazuhiro, Minato-ku, Tokyo (JP); Yoshiki, Masayuki, Minato-ku, Tokyo (JP)
(74) Representative: Betten & Resch

(57) **Abstract**

A field-emission type cold cathode using a carbon material as its emitter, has a plurality of acicular carbon film protrusions on its substrate electrode (1), thus having large current properties.

Also, by performing ECR plasma processing, in an atmosphere of hydrogen, on a carbon film (2) formed on the substrate electrode (1), such a field-emission type cold cathode can be easily formed that has acicular emitters made of carbon arranged close to each other.

## Description

### BACKGROUND OF THE INVENTION

### 1.Field of the Invention:

The present invention relates to a carbon material, a method for manufacturing the same material, a field-emission type cold cathode using the same material and a method for manufacturing the same cathode and, more particularly, to a field-emission type cold cathode having an emitter which emits electrons and a method for forming an acicular emitter in a field-emission type cold cathode having emitters which use the carbon material as a carbon film.

### 2.Description of the Related Art:

A field-emission type cold cathode is attracting world attention because it can act as an electron gun, in place of a hot cathode, which is capable of emitting electrons in a vacuum by applying an electric field on an emitter. In particular, attention is given to a cone-shaped emitter having a minute cone shape and a method for using a diamond as an emitter material. The cone-shaped emitter having a minute cone shape has come to be able to be made by the recently advanced microlithography for semiconductor devices in sub-micron processing, whereby a minute electron source can be easily formed. A material of diamond, on the other hand, has a variety of advantages as an electron-emission element such as a large hardness, a chemical stability, and a negative electron affinity that the energy level of a semiconductor surface is lower than that in a vacuum. The negative electron affinity of a diamond gives itself such an advantage that when electrons are supplied to the conduction band of the diamond to reach its surface, electrons can be emitted in a vacuum.

With this, such technologies have been proposed as using a diamond as an emitter material. For example, according to one of such technological methods, the surface of a minute electron source formed in a cone is coated with a thin film of diamond or that of such carbon as diamond-like carbon. This method has an advantage that a cone-shaped field-emission type cold cathode can be made only by adding a step of depositing a thin film of diamond to a cone tip by a CVD (Chemical Vapor Deposition) method etc. Another method is also proposed for etching the diamond film itself. It is disclosed in Japanese Laid-Open Patent Application No. Hei6-132254.

According to this method, a mask material such as aluminum is formed on the surface of a diamond film and then a mixture gas containing argon and oxygen is used to perform plasma etching on the diamond film selectively. This method is advantageous in that it provides a higher selection ratio between a mask material and a diamond, thus giving a higher degree of fine patterning. It is reported also that when this method is employed in plasma etching by use of an oxygen gas, the selection ratio for a mask material becomes indeed even higher but, the diamond surface is degraded in terms of flatness, thus creating a columnar construction of 10-50 nm in size.

Still another method is disclosed in Japanese Laid-Open Patent application No. Hei9-265892 for forming a diamond film on a protrusion-shaped emitter tip.

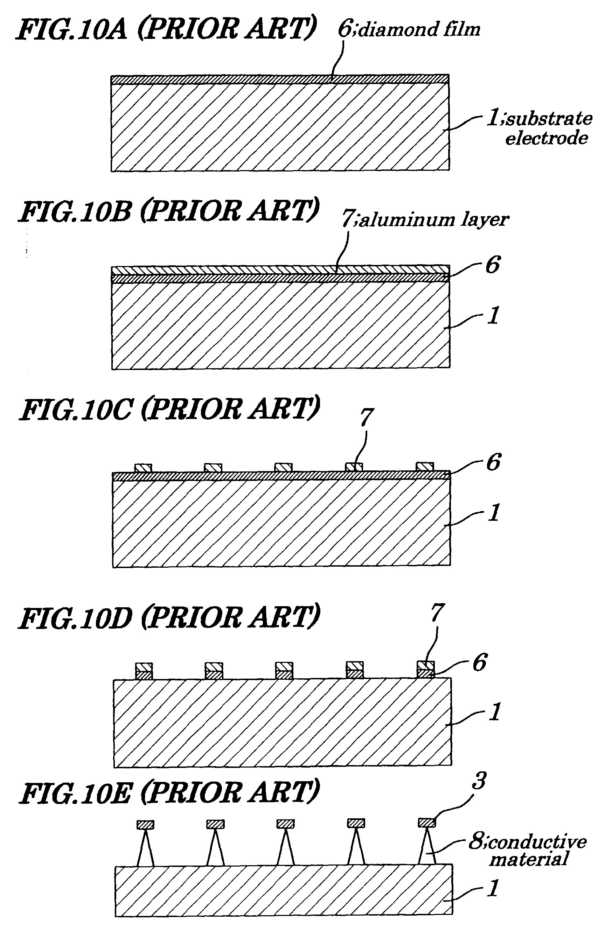

Figs. 10 are cross-sectional views illustrating sequential steps of a conventional example. According to a construction shown in the figure, on a substrate electrode consisting of for example a silicon substrate is formed a protrusion-shaped conductive material 8 made of for example silicon, on a tip of which is formed a diamond. This manufacturing method is described below along the sequence of steps. First, as shown in Fig. 10A, a substrate electrode 1 is provided with a diamond film 6 formed thereon using a CVD method. Next, as shown in Fig. 10B, an aluminum layer 7 which acts as a mask for processing the diamond is formed by a vacuum evaporation method. Next, as shown in Fig. 10C, a photolithographic method is used to etch a photo-resist into such a desired pattern as having for example a five-micron diameter and a 20micron spacing, which is in turn used as a mask to pattern the aluminum layer 7. Next, as shown in Fig. 10D, with the aluminum layer 7 used as a mask, the diamond 6 is patterned by means of reactive ion etching using an oxygen gas. Next, as shown in Fig. 10E, the aluminum layer 7 is removed and then, using the diamond 6 as a mask, the substrate electrode 1 is etched by reactive ion etching, to form a protrusion-structured conductive material 8. These steps complete the formation of a field-emission type cold cathode having an emitter wherein the diamond 6 is formed on the protrusion-structured conductive material 8. According to this method, the processing is rather easy because the diamond is formed only on the protrusion-structured conductive material 8 and the protrusion structure is formed with the conductive material 8 which is easy to etch.

Still another method comprises a step of forming a nano-fiber made of graphite grown selectively, which is disclosed in pages 2119-2121 of volume 73, number 15 of the Applied Physic Letters published in 1998.

According to this method, in an atmosphere containing nitrogen and acetylene, a plasma-assisted CVD method is performed on a substrate made of nickel, to cause fiber-like graphite to grow on the substrate. It is reported that by this method, a nano-fiber measuring 30-100 nm in size is formed.

A first problem of the conventional technology shown in Figs. 10 is that since a cone-shaped emitter is formed and then such a carbon film as made of a diamond is coated on that, the radius of curvature of the tip of the emitter is rather large, thus being disadvantageous in the emission of electrons. The field-emission properties in general depend largely on the radius of curvature and work function of the tip of the emitter material. With this, therefore, even when a diamond or the like material liable to emit electrons is coated on the surface of a con-shaped emitter, the radius of curvature of the tip is increased by as much as the thickness of the coated film. As a result, although the emission performance is improved by the coating material, the radius of curvature of the tip becomes large, thus offsetting and limiting the emission performance.

A second problem of the conventional technology is that since an oxygen gas is mainly used as an etching gas for a diamond, the diamond surface is liable to be oxygen-terminated. An oxygen gas has indeed an advantage that it has a higher etching rate as compared to a diamond and also a high selection ratio as compared to aluminum etc. as a mask material. When an oxygen gas is used in etching of a diamond, however, the diamond surface has an oxygen-terminated construction, so that it cannot enjoy negative electron-affinity properties that can be obtained with hydrogen termination, thus being degraded in terms of emission performance, which leads to a problem. Moreover, although the diamond surface, when hydrogen-terminated, has higher conductivity and is easy to supply emission electrons for to the tip of an emitter, the oxygen-terminated surface supply those electrons via a diamond bulk with a lower conductivity to the emitter tip, thus being rendered disadvantageous in obtaining of a large emission current when the emitter is formed only of a diamond.

The third problem is that although a diamond which is processed using an oxygen gas as a main etching gas provides a higher selection ratio with a mask material, a columnar structure created inherently makes it difficult to apply an electric field on a protrusion-shaped tip of an emitter. As mentioned above, since the emission properties largely depend on the radius of curvature of the emitter tip, it is advantageous for the better emission properties to have a small shape of a sharp tip with a small radius of curvature. When oxygen is used in etching in fact, a columnar structure is given a flat shape of the tip, which is advantageous in emission.

The fourth problem is that since the emitter is shaped in such a manner that a protrusion-shaped emitter may be formed with a material rather easy to form, thus depositing a diamond on the tip, the shape of a diamond formed on the tip is determined by a photolithographic method of forming a diamond, thereby making it difficult to fine-pattern the tip and reduce an inter-emitter distance. The fine patterning limits by photography is considered to be a sub-micron order for the diamter and the inter-pattern distance. This conventional technology, therefore, can give a radius of curvature of the tip which is only 10 times or more as large as about 10 nm, which is given by a cone-shaped minute emitter, thus being disadvantageous in emission. Furthermore, although the larger the number of emitters the easier in emission of electrons, the inter-emitter distance is restricted, thus limiting the improvements in the performance of emission.

The fifth problem is that the method of forming a nano-fiber brings about an acicular emitter consisting of a graphite fiber, so that only a graphite quality of film can be obtained, thus making it impossible in some cases to obtain a negative electron affinity that can be obtained with a diamond. Furthermore, the shape is limited to a fiber construction, so that although a diameter of tip of about 30 nm at the minimum can be obtained, only a diameter of about 60-70 nm is mainly obtained, thus restricting the micro-processing of the tip.

### SUMMARY OF THE INVENTION

In view of the above, it is an object of the present invention to provide a field-emission type cold cathode that is capable of having a plurality of sharply shaped emitters made of such a carbon film as a diamond, with improved emission point and emission properties, thus obtaining a large emission current even at a low voltage.

According to a first aspect of the present invention, there is provided a carbon material wherein a surface of a carbon film is covered with an acicular protrusion structure made of carbon.

In the foregoing, a preferable mode is one wherein the carbon film surface is covered with an acicular protrusion-shaped structure made of carbon.

Also, according to a second aspect of the present invention, there is provided a method for manufacturing a carbon material which comprises a step of performing plasma processing on a carbon film in an atmosphere of hydrogen, to form an acicular carbon film on a surface of said carbon film.

In the foregoing second aspect, a preferable mode is one wherein a method for manufacturing a carbon material comprises a step of performing plasma processing in an atmosphere of oxygen before or after said step of performing plasma processing in an atmosphere of hydrogen.

Also, a preferable mode is one wherein the method for manufacturing a carbon material comprises a step of etching said carbon film during said plasma processing, to form an acicular carbon film.

Also, a preferable mode is one wherein the method for manufacturing a carbon material comprises a step of forming a material with a different etching rate in or on a surface of said carbon film during the plasma processing in an atmosphere of hydrogen, to use that material with a low etching rate as a mask during the etching of that carbon film, thus making it possible to form an acicular emitter in a self-alignment manner.

Also, a preferable mode is one wherein the method for manufacturing a carbon material comprises a step of forming said carbon film in such a way that said carbon film may have an sp2 structure and an sp3 structure mixed therein.

Also, a preferable mode is one wherein said plasma processing is performed using ECR (Electron Cyclotron Resonance) plasma.

Furthermore, a preferable mode is one wherein said ECR plasma processing is performed with a bias being applied to a substrate in a processing apparatus.

Also, according to a third aspect of the present invention, there is provided a field-emission type cold cathode having a carbon material according to the first aspect as an emitter.

Also, according to a fourth aspect of the present invention, there is provided a method for manufacturing a field-emission type cold cathode which comprises a step of forming an acicular protrusion structure which provides an emitter, using said method for manufacturing a carbon material according to the third aspect.

In the foregoing fourth aspect,, it is possible to provide a high-performance field-emission type cold cathode that can obtain a large emission current even at a low voltage, since by forming an emitter made of a carbon film with a plurality of tips having a sharp and acicular shape, it is possible to give a higher field strength applied to the emitter tip and a larger number of emitter points.

Also, a diamond film having better emission performance, i.e. sp3-sturctured carbon film, and a graphite film having higher conductivity, i.e. sp2-structured carbon film are combined into a composite carbon film used as an emitter material, thus making it possible to provide a field-emission type cold cathode having both high conductivity and large emission-current properties. This configuration provides even better emission properties by arranging an sp3-structured carbon film on the emitter tip.

Also, it is possible to perform plasma processing on a carbon film in an atmosphere of hydrogen to easily form a plurality of sharp and acicular emitters at the same time.

With the above configurations, it is possible to form both a mask for forming a carbon film and a mask for forming an emitter by means of a same film-forming apparatus by simultaneously forming an sp2-structured carbon film having a higher etching rate and another carbon film having a lower etching rate when they are formed in hydrogen plasma processing. Moreover, since an sp3-structured carbon film with better emission properties is formed at the tip of an emitter in a self-alignment manner, it is possible to improve the emission properties of the emitter as well.

Furthermore, since hydrogen plasma processing is performed using ECR (Electron Cyclotron Resonance) plasma, thus making it possible to obtain better plasma performance to easily form sharp and acicular emitter.

Still furthermore, hydrogen plasma processing, when performed, makes it possible to cover the surface of an acicular emitter with an amorphous carbon film or an preferably an sp2-structured conductive film made of carbon so as to form a field-emission type cold cathode having higher conductivity.

Still furthermore, by providing such a structure in which an acicular emitter may reach a lower substrate electrode, a field-emission type cold cathode with higher conductivity can be formed.

### BRIEF DESCRIPTION OF THE DRAWINGS

The above and other objects, advantages and features of the present invention will be more apparent from the following description taken in conjunction with the accompanying drawings in which:
Figs. 1A, 1B and 1C are schematic cross-sectional views showing a field-emission type cold cathode and steps for manufacturing the same according to a first embodiment of the present invention;
Figs. 2A, 2B and 2C are schematic cross-sectional views showing a field-emission type cold cathode and steps for manufacturing the same according to a second embodiment of the present invention of;
Figs. 3A, 3B and 3C are schematic cross-sectional views of a field-emission type cold cathode and steps for manufacturing the same according to a third embodiment of the present invention;
Fig. 4 is a schematic cross-sectional view of a fourth embodiment of the present invention of
Figs. 5A, 5B, 5C and 5D are cross-sectional views showing sequential steps for manufacturing a field-emission type cold cathode according to a fifth embodiment of the present invention;
Figs. 6A, 6B, 6C and 6D are cross-sectional views showing sequential steps for manufacturing a field-emission type cold cathode according to a sixth embodiment of the present invention;
Figs. 7A, 7B, 7C and 7D are cross-sectional views showing sequential steps for manufacturing a field-emission type cold cathode according to a seventh embodiment of the present invention;
Figs. 8A, 8B, 8C and 8D are cross-sectional views showing sequential steps for manufacturing a field-emission type cold cathode according to an eighth embodiment of the present invention;
Fig. 9 is a photograph showing a carbon film in which an acicular protrusion structure is formed by etching; and
Figs. 10A, 10B, 10C, 10D and 10E are cross-sectional views showing a conventional field-emission type cold cathode and sequential steps for manufacturing the same.

### DESCRIPTION OF THE PREFERRED EMBODIMENTS

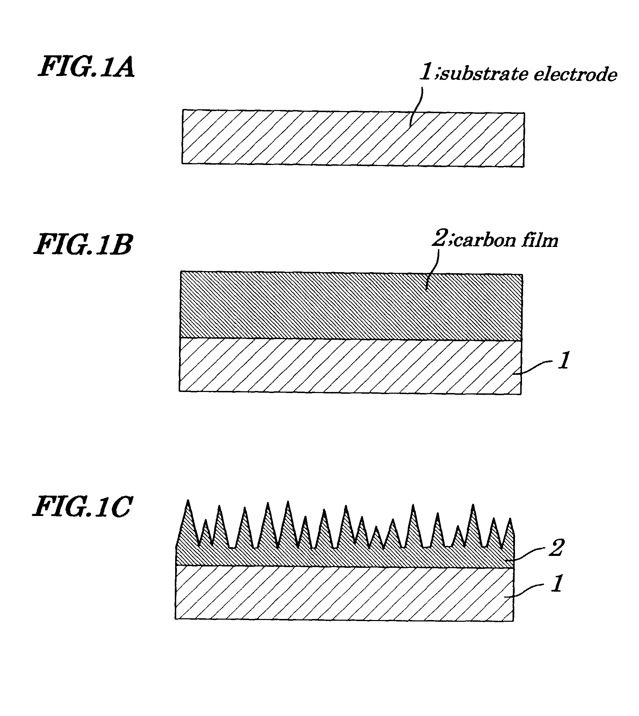

Now the preferred embodiments of the present invention are described below with reference to the appended drawings. As shown in Fig. 1C, a first embodiment of the present invention has such a construction that on a substrate electrode 1 which provides a conductive cathode electrode, a carbon film 2 is formed which is covered, on its upper surface, with a sharp and acicular protrusion-shaped structure. This acicular protrusion-shaped structure has a cone or pyramid shape with a bottom-surface width of from a few to 200 nm and a height of from about 10 nm to 1 µm disposed with almost the same pitch as the bottom-surface width. By providing such a construction as having emitters close to each other made of acicular carbon films with a sharp tip, it is possible to obtain a larger current from each of these emitters because its tip has a large sharpness degree and also to obtain a larger emission current because a large number of these emitters is arranged close to each other. Moreover, since a film with a higher sp3-nature is used as a carbon film, diamond characteristics can be obtained to improve the emission properties even further. By providing herein such a construction as having its surface being hydrogen-terminated, the electric conductivity on the diamond surface is improved, thus making it even easier to obtain an emission current.

Next, a manufacturing method is described as follows. As shown in Fig. 1A, for example an n-type silicon substrate is provided as a substrate electrode 1. Although this substrate is made of silicon, any appropriate substrate electrode made of other materials may be used such as one having metal formed on its glass substrate in an application field of, for example, display.

Next, as shown in Fig. 1B, on the substrate electrode 1, the carbon film 2 is deposited as thick as about 5 µm using a hot-filament CVD method. According to one example of conditions for forming the carbon film, diamond powders with a grain diameter of about 1 µm are attached onto the surface of the substrate electrode 1 by performing scratch processing, which electrode 1 is in turn placed in a hot-filament CVD chamber which is exhausted down to about 10⁻⁶ Torr, into which is then introduced for example methane/hydrogen at a flow rate of about 5 sccm/500 sccm, to form the carbon film at a pressure of 20 Torr. In this case, the filament temperature is about 2200°C and the substrate temperature is about 800°C. It is known based on the Raman evaluation that by performing the above-mentioned steps, a polycrystalline carbon film with a high sp3-nature is formed. Although in this embodiment, before the step of film formation, diamond powders are attached to the substrate electrode by scratch processing, any other appropriate method may be used in attachment or the film may be formed without scratching the powders. Still although the above-mentioned procedure employed the hot filament CVD method in the formation of the film, other methods may be used for the film formation, such as for example a microwave plasma CVD method, a direct-current arc method, or a burning-flame method.

Next, as shown in Fig. 1C, hydrogen is introduced at a flow rate of about 40 sccm to perform such processing that ECR plasma with a power of about 500 watts is generated by applying a magnetic field of about 850-900 gausses and a microwave having a frequency of about 2.5 GHz to an ECR ion source at a pressure of from about 10⁻⁴ to 10⁻³ Torr. With this, the carbon film is provided on its surface with acicular structures formed close to each other. This acicular structure is made because such phenomenon occur independently or in a composite manner as one that by the ECR plasma processing, a structure of the carbon film or a deposition on its surface or a re-grown product acts as a mask for etching the carbon film and another that the carbon film changes in shape selectively because of a difference in surface orientation of the carbon film or etching rate for the grains of the polycrystalline structure.

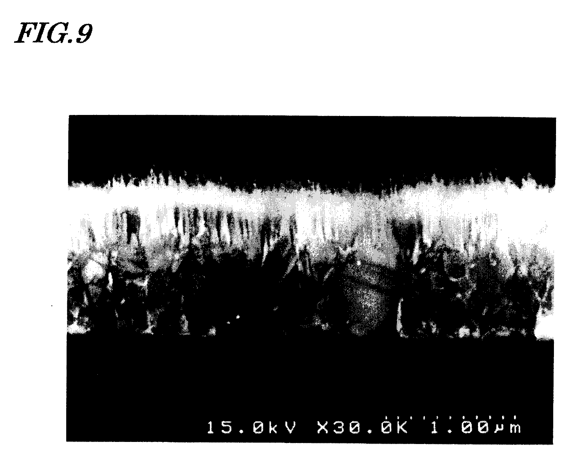

Also, the present invention has another advantage that etching according to the present invention does not use as the main etchant component an argon gas having an etching rate irrespective of the material, to prevent rapid removal of the mask material in etching, thus resulting in the formation of protrusions with a high aspect ratio. Moreover, the present invention does not employ as the main etchant component an oxygen gas with a high selection ratio, thus preventing the formation of a columnar structure other than an acicular structure and also avoiding the removal, by etching, of the carbon film before the formation of an acicular structure because the etching rate is not so high as with oxygen. Fig. 9 shows a photograph of the carbon film after being etched.

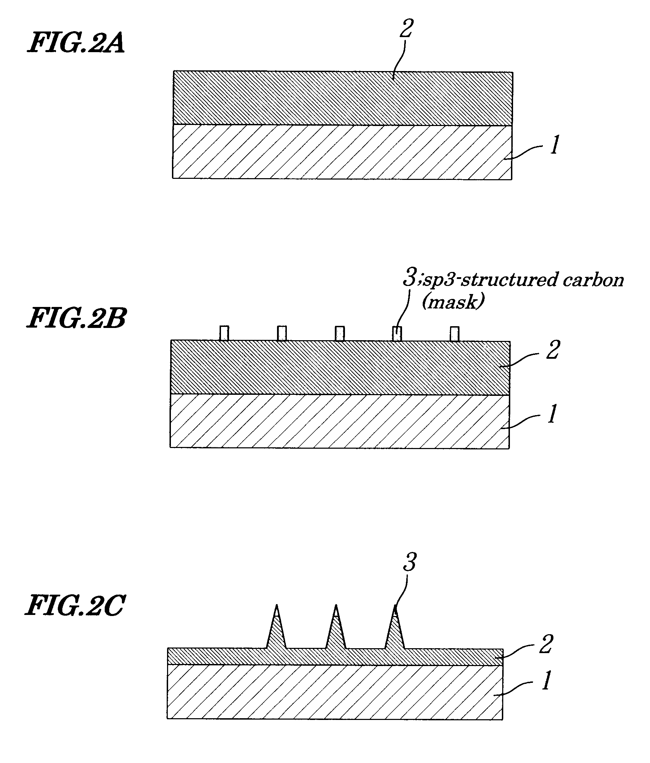

Now, a second embodiment of the present invention is described. As shown in Fig. 2C, the second embodiment of the present invention has such a construction that on a substrate electrode 1 which provides a conductive cathode electrode is formed a carbon film 2 which is covered on its upper surface with a protrusion-shaped structure, on the tip of which film 2 is formed an sp3-structured carbon 3 having a sharp shape. The protrusion-shaped structure has a cone or pyramid shape having a bottom surface width of from several to 200 nm and a height of from about 10 nm to 1 µm. By providing the tip of an acicular construction made of such an sp3-structured carbon film, diamond-like emission properties can be obtained. This sp3-structured carbon 3 has a radius of curvature of 100 nm or less, preferably 10 nm or so. This is because the emission properties of an acicular emitter largely depends on the radius of curvature of the tip. Moreover, when the carbon film 2 is of an sp2 structure, low-resistance graphite-like properties can be obtained, thus being advantageous in supplying of an electric current to the tip of an acicular structure which acts as an emission point as compared to a case where the carbon film 2 is of an sp2 structure.

Next, a manufacturing method according to the second embodiment of the present invention is described as follows. As shown in Fig. 2A, for example on the substrate electrode 1. The carbon film 2 is formed as thick as about 5 µm by for example a hot-filament CVD method. Then, as shown in Fig. 2B, a grain-like sp3-structured carbon 3 is formed on the surface of the carbon film 2 by for example scratching a diamond. Then, as shown in Fig. 2C, ECR plasma processing by use of a hydrogen gas is performed, to etch the carbon film 2 using the sp3-structured carbon film 3 as a mask. In this step, by using an sp3-structured graphite film in place of the carbon film 2, it is possible to obtain an appropriate value of selection ratio with the sp3-structured surface carbon film and also to obtain such an acicular shape as leaving the sp3-structured carbon film 3 on the tip because as the carbon film 2 is etched in a depth direction, the sp3-structured carbon 3 is also etched in reduced in area.

Note here that by elongating ECR plasma processing in time, it is also possible to remove the sp3-structured carbon 3 on the tip. With this, a field-emission type cold cathode according to the first embodiment can be formed. As mentioned above, the present embodiment makes it possible to selectively form, in an easy manner, the tips of acicular emitters arranged in a uniform height of an sp3-structured diamond with large emission-current properties. Although, in this present embodiment, an example has been described in which the sp3-structured carbon film 3 is formed by scratch processing, it is not restrictive. Alternatively, a hot-filament CVD method may be performed at a substrate temperature of about 600°C to form a carbon film on the surface of the carbon film 2, thus resulting in sp2 and sp3 structures being mixed in the carbon film. Thus formed sp3-structured carbon in this film may be used as a mask. By this method, it is possible to control the drain diameter of the sp3-structured carbon depending on the film forming conditions, thus enabling more delicate control of the diameter than the case of scratching. Also, since that film can be formed subsequent to the formation of the carbon film 2, the process can be simplified, which is another advantage of the present invention.

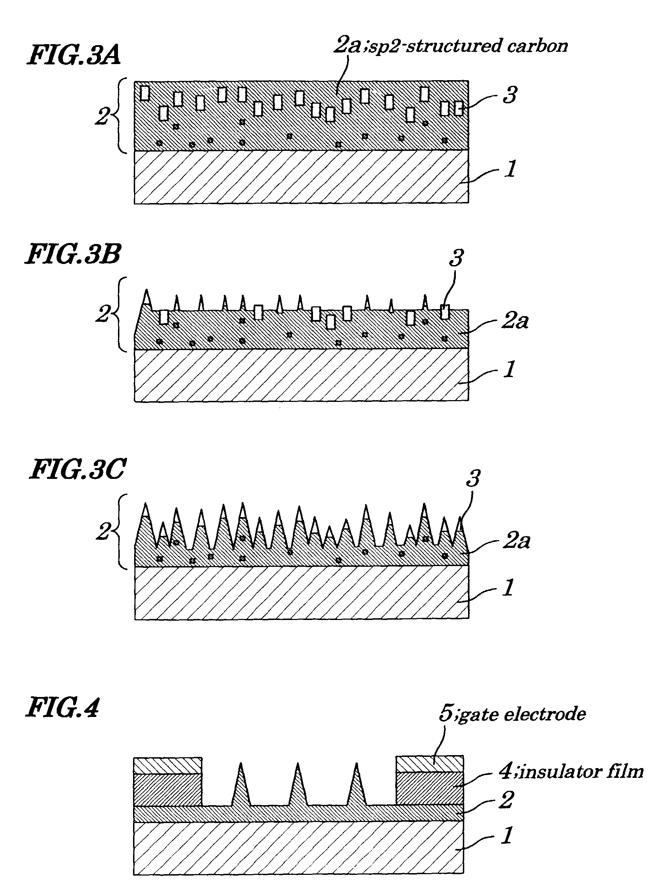

Next, a third embodiment of the present invention is described. As shown in Fig. 3C, the third embodiment of the present invention has such a construction that on a substrate electrode 1 which provides a conductive cathode electrode is formed a carbon film 2 which is covered on its upper surface with a protrusion-shaped structure and which contains sp3-structured carbon 3. Also, as shown in the figure, the sp3-structured carbon 3 may be arranged at the tip of an acicular protrusion which provides an emitter. The protrusion-shaped structure is of a cone or pyramid shape, having its bottom surface width from of a few to 200 nm of and a height of from about 10 nm to 1 µm and being arranged with almost the same pitch as the bottom surface width therebetween. Preferably, the carbon film 2 in this embodiment is mainly of an sp2 structure. By forming such carbon film 2 as being mainly of an sp2 structure, it is possible to form a low-resistance acicular protrusion which is advantageous in the supply of an emission current. Furthermore, by providing the tip of the acicular structure made of an sp3-structured carbon film, diamond-like emission properties can be obtained.

Next, a manufacturing method according to the third embodiment is described as follows. As shown in Fig. 3A, on the substrate electrode 1 made of a silicon substrate is formed the carbon film 2, to a thickness of about 5 µ, which is mainly of for example an sp2 structure being low in etching rate in a hydrogen-plasma processing as compared to sp3-structured carbon. Then, as shown in Figs.3B through 3C, the carbon film 2 is etched in ECR plasma processing by use of a hydrogen gas. A half-way shape in the ECR plasma processing is, as shown in Fig. 3B, is such that the carbon film 2 is gradually etched, during which the sp3-structured carbon 3 contained in the film is exposed and then acts as a mask because of its low etching rate, thus forming an acicular protrusion. By setting the ECR plasma conditions or the film properties so as to obtain an appropriate selection ratio, it is possible to obtain such an acicular shape with the sp3-structured carbon film 3 left at the tip because the carbon film is etched in the depth direction and, at the same time, the sp3-structured carbon film 3 is also etched and reduced in size. When ECR processing is performed subsequently, the sp3-structured carbon film 3 formed deep in the carbon film 2 is exposed as shown in Fig. 3C, which then acts as a mask to form the acicular protrusion. With this, a number of the acicular protrusions with different heights is formed everywhere in the surface.

Note here that this method is capable of removing the sp3-structured carbon film 3 by elongating the ECR plasma processing in time. It is also possible to adjust the height of the acicular protrusion by adding oxygen-plasma processing. It is preferably also that the grain diameter of the sp3-structured carbon 3 contained in the carbon film be finally 10 nm or less in order to determine the diameter of the emitter tip. To form an acicular protrusion having an aspect ratio of 10 or higher, the selection ratio must be 10 or so. If, in this case, the sp3-structured carbon 3 is to be etched in an isotropic manner in the ECR plasma processing, its grain diameter must be that of the emitter tip multiplied by the selection ratio. Therefore, it is preferably 100 nm or so.

This method has such an advantage that when the carbon film 2 is being formed, the sp3-structured carbon 3 can also be formed simultaneously which acts as a mask for forming an acicular protrusion in the film, thus reducing the number of steps required. Moreover, the sp3-structured carbon 3 contained in the film can be used as a mask to arrange the sp3-structured carbon film 3 having large emission-current properties at the acicular protrusion, i.e. emitter tip in a self-alignment manner. Furthermore, in the present configuration, the sp3-structured carbon 3 is arranged which acts as a mask for forming an acicular protrusion also in the depth direction of the carbon film 2, to enable forming an acicular protrusion also between the existing acicular protrusions, thus largely improving the in-surface density of acicular protrusions.

Next, a fourth embodiment of the present invention is described as follows. In such a configuration as shown in Fig. 4, on a substrate electrode 1 which provides a conductive cathode electrode is formed a carbon film 2 covered on its upper surface with a protrusion structure having a height of for example about 1 µm, on which is formed a gate electrode 5 made of a metal film with a thickness of about 200 nm via an insulator film 4 consisting of an oxide film with a thickness of for example about 800 nm. Although this exemplified configuration of a carbon film 3 having an acicular protrusion which provides an emitter is shown according to the first embodiment of the present invention, it is not restricted to the first embodiment but such an emitter as according to the second or third embodiment may be employed. In a configuration according to the fourth embodiment of the present invention for example, the gate electrode 5 is arranged in the vicinity of an emitter, thus making it possible to apply a desired electric field on the tip of the emitter at a low voltage for easily obtaining higher emission properties.

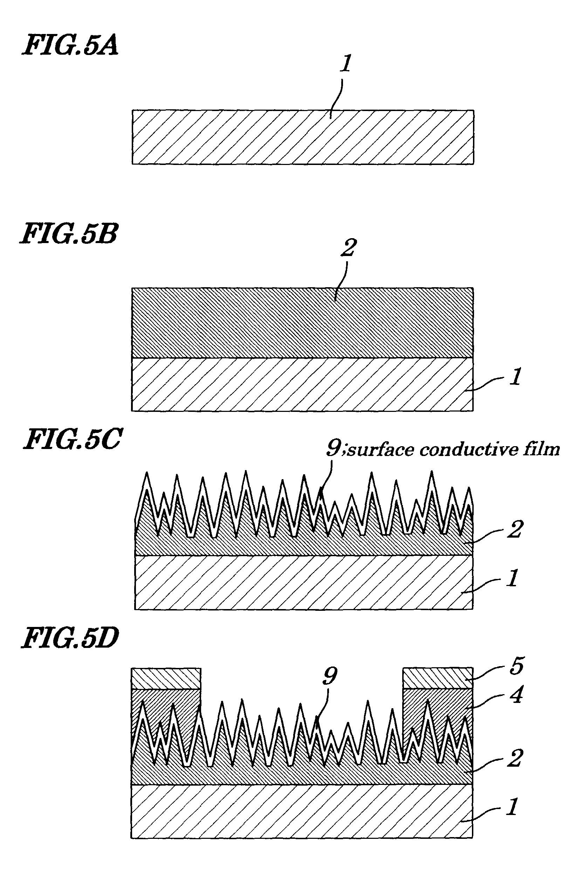

Next, a fifth embodiment of the present invention is described in detail with reference to the drawings. Fig. 5D shows a cross-sectional view of a field-emission type cold cathode device according to the fifth embodiment of the present invention. A substrate electrode 1 is a material which serves as a base when a cold cathode material is deposited, acting also as a lower electrode. The substrate electrode 1 used in the fifth embodiment may be made of a semiconductor substance or any conductor such as for example Si, Mo, Fe, Ni, or Pt. Also, a glass-like insulating substrate on which a metal film is attached, evaporated, or deposited may be used as a substrate electrode. A carbon film 2 which provides a cold cathode material is provided for emitting electrons. This carbon film 2 has n acicular protrusion-structured surface. A surface conductive film 9 consists of a carbon film containing an sp2 structure, having high conductivity as compared to the carbon film 2, as well as a thickness of 10 nm or less and a surface resistivity of 10⁵Ωcm or less. The surface conductive film 9 constitutes part of a path for supplying electrons, so preferably has a low resistivity, for example 10⁵Ωcm or less. An insulator film 4 is an insulating material which electrically isolates the carbon film 2 and a gate electrode 5 from each other, consisting mainly of an oxide film etc. The gate electrode 5 is provided to draw electrons, consisting of a metal thin film.

As shown in Fig. 5A, an n-type silicon substrate is used as the substrate electrode 1. Then, as shown in Fig. 5B, on this substrate electrode 1 is formed, to a thickness of 5 µ, a polycrystalline diamond as the carbon film 2 using a CVD method. Then, as shown in Fig. 5C, the surface of the carbon film 2 is exposed to hydrogen plasma. This hydrogen plasma processing generated is of an ECR type. In this processing, impurities and minute defects present in the CVD-polycrystalline diamond film are selectively etched, thereby resulting in an acicular structure. This method need not use a lithographic step for processing a cold cathode material itself. Also, in the step of etching, hydrogen plasma damages the carbon film 2, thus forming the surface conductive film 9 consisting of an amorphous carbon film or preferably a carbon film containing an sp2 structure both on the surface of the carbon film 2 and on the surface of the acicular protrusion structure. Then, as shown in Fig. 5D, after both the insulator film 4 and the metal film which provides the gate electrode 5 are deposited, the insulator film 4 and the gate electrode 5 are patterned into a desired shape performing a lithographic step. Although according to the present embodiment, hydrogen plasma processing alone is performed to form an acicular structure, oxygen plasma processing may be performed before the hydrogen plasma processing. By thus performing oxygen plasma processing, an acicular protrusion structure can be formed by hydrogen plasma processing with the carbon film 2 being reduced thinner, thus easily forming causing an acicular protrusion structure to grow on the surface of the substrate electrode 2, which is an advantage of the present invention. Although the above-mentioned procedure forms the insulator film and the gate electrode after giving an acicular structure to the carbon film 2 using hydrogen plasma, the insulator film 4 and the gate electrode 4 may be formed first and then the carbon film 2 may be processed into an acicular structure. Also, although in the present embodiment example, the carbon film 2 below the insulator film 4 is formed as reduced acicular, the acicular shape of the carbon film 4 below the insulator film 4 may be removed beforehand by oxygen plasma etching etc. to provide a flattened structure, before the insulator film 4 is formed thereon.

Next, the behavior of a field-emission type cold cathode according to the fifth embodiment of the present invention in detail with reference to Fig. 5D. To operate the field-emission type cold cathode according to the present embodiment, a negative bias or a positive bias is applied to the substrate electrode 1 or the gate electrode 5 respectively. Then, an electric field is concentrated at the tip of the carbon film 2 rendered acicular protrusion-structured, thus making it possible to decrease the voltage to be applied to the substrate electrode 1 or the gate electrode 5. Table 1 lists the threshold field strength of an as-grown diamond film (sample 1) before hydrogen plasma processing, another diamond film (sample 2) covered with a diamond film which has an acicular structure on its surface caused by hydrogen plasma processing and which contains in its surface an sp2 structure, and still another diamond film (sample 3) obtained by removing this carbon film containing the sp2 structure by oxidizing agent or oxygen plasma. A reference current density employed in this case is 10 µA/cm². Based on the results, it is found that sample 2 has the lowest threshold field strength, with improved field-emission properties.

**Table 1**

| | sample 1 | sample 2 | sample 3 |
|---|---|---|---|
| threshold field strength | 120V/µm | 1V/µm | 7V/µm |

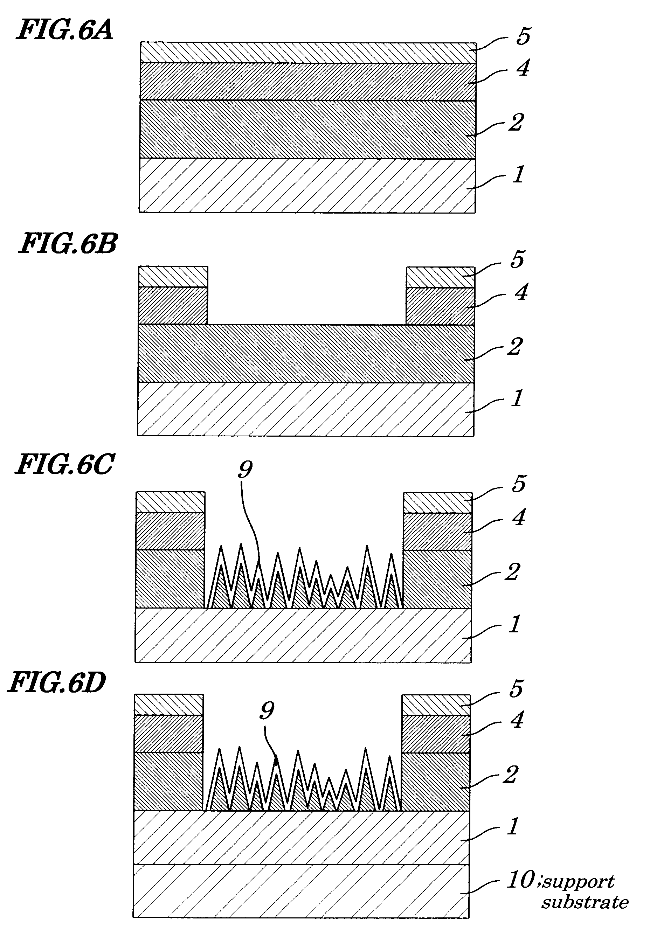

Next, a sixth embodiment of the present invention is described in detail with reference to the drawings. Fig. 6D is a cross-sectional view of the sixth embodiment of the present invention. A substrate electrode 1 constitutes a lower electrode. This substrate electrode 1 may be made of a semiconductor substance or any conductor such as for example Si, Fe, Ni, or Pt. A carbon film 2 consists of a cathode material, preferably containing sp3-structured carbon. This carbon film 2 has an acicular protrusion-shaped structure on its surface. A surface conductive film 9 consists of an amorphous carbon film or preferably a carbon film containing an sp2 structure, having high conductivity as compared to the carbon film 2 as well as a thickness of 10 nm or less and a surface resistivity of 10⁵Ωcm or less. Since the surface conductive film 9 is part of a path for supplying electrons, its resistivity is preferably low, for example 10⁵Ωcm. An insulator film 4 consists of an insulating material mainly made of an oxide film etc., for electrically isolating the carbon film 2 and the gate electrode 5. The gate electrode 5 is provided for drawing electrons from the carbon film 2, consisting of a metal thin film. A support substrate 10 constitutes a base for the field-emission type cold cathode, being made of such an insulating material as glass, plastic, ceramic, etc.

As shown in Fig. 6A, on the substrate electrode 1 made of Mo is formed the carbon film 2 containing for example a polycrystalline diamond as the cold cathode material using a CVD method. In this case, the carbon film 2 is formed to a film thickness of about 5 µm. Then, an oxide film which provides the insulator film 4 and a metal film which provides the gate electrode 5 are deposited. Then, as shown in Fig. 6B, the insulator film 4 and the gate electrode 5 are processed into an arbitrary shape performing a lithographic step. Then, as shown in Fig. 6C, the surface of the carbon film 2 is exposed to hydrogen plasma. During this plasma processing, impurities and minute defects present in the CVD-polycrystalline diamond film are selectively etched, to provide an acicular protrusion structure. In this etching, such a configuration is given that the acicular protrusion structure may reach the surface of the substrate electrode 1 from the surface of the carbon film 2. Another configuration may be given such that part of the surface of the substrate electrode 1 may be over-etched. By providing, in this etching step, such hydrogen-plasma processing conditions as damaging the carbon film 2, the surface conductive film 9 consisting of an amorphous carbon film or preferably a carbon film containing an sp2 structure is formed both on the surface of the carbon film 2 and on the surface of the acicular protrusion structure. Although, in the present embodiment of the present invention, the insulator film 4 and the gate electrode 5 are formed on the carbon film 2, which then undergoes hydrogen plasma processing to form an acicular structure, the carbon film 2 may beforehand undergo hydrogen plasma processing to provide the acicular structure, thereby subsequently forming the insulator film 4 and the gate electrode 5. Finally, as shown in Fig. 6D, the support substrate 10 which provides the support base is laminated to the back side of the substrate electrode 1.

Next, the behavior of a field-emission type cold cathode according to the sixth embodiment of the present invention is described in detail with reference to fig. 6D. To operate the field-emission type cold cathode according to the present embodiment, a negative bias or a positive bias is applied to the substrate electrode 1 or the gate electrode 5 respectively. With this, an electric field is concentrated at the tip of the carbon film 2 the surface of which is rendered acicular protrusion-shaped and, at the same time, that acicular protrusion portion has reached the substrate electrode 1, so that electrons can be easily supplied from the substrate, thus decreasing the voltage to be applied to the substrate electrode 1 or the gate electrode 5.

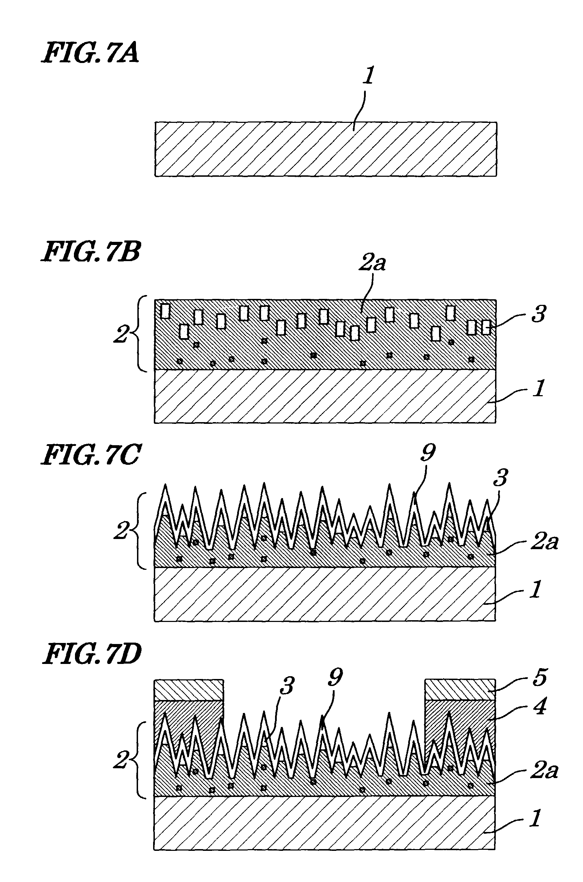

Next, a seventh embodiment of the resent invention is described in detail with reference to the drawings. Fig. 7D shows a cross-sectional view of a field-emission type cold cathode according to the seventh embodiment of the present invention.

A substrate electrode 1 is a substance which provides a base for depositing a cold cathode material, acting also as a lower electrode. This substrate electrode 1 maybe made of a semiconductor substance or any conductor such as for example Si, Mo, Fe, Ni, or Pt. Also, as the substrate, such a glass-like semiconductor substrate may be used on which a metal film is attached, evaporated, or deposited. The carbon film 2 which provides the cold cathode material is provided for emitting electrons. This carbon film 2 is a cathode material for emitting electrons, comprising sp3-structured carbon 3 and sp2-structured carbon 2a. The carbon film 2 has an acicular protrusion-structured surface. A surface conductive film 9 consists of an amorphous carbon film or preferably a carbon film containing an sp2 structure, having high conductivity as compared to the carbon film 2 as well as a thickness of 10 nm or less and surface resistivity of 10⁵Ωcm less. Since the surface conductive film 9 is part of a path for supplying electrons, its resistivity is preferably low, for example 10⁵Ωcm. The insulator film 4, mainly formed with an oxide film etc., is an insulating material which electrically isolates the carbon film 2 and the gate electrode 5. The gate electrode 5 is provided to draw electrons from the carbon film 2, consisting of a metal thin film.

As shown in Fig. 7A, an n-type silicon substrate is used as the substrate electrode 1. As shown in Fig. 7B, on this substrate electrode 1, the carbon film 2 is formed using a CVD method or sputtering method. In the present embodiment, on the substrate electrode 1, a diamond-like carbon film is formed, to a supposed thickness of 3 µm, as the carbon film 2 which is the cold cathode material. This carbon film has the sp2-structured carbon 2a which is dotted therein with sp3-structured carbon 3. Then, as shown in Fig. 7C, the surface of the carbon film 2 is exposed to hydrogen plasma. Then, as shown in Fig. 7C, the surface of the carbon film 2 is exposed to hydrogen plasma. During this hydrogen plasma processing, the sp3-structured carbon 3 acts as a mask to selectively etch the sp2-structured carbon 2a, thus providing an acicular protrusion structure. This is because a strong bonding strength of the sp3 structure as compared to that of the sp2 structure causes selective etching to occur. By setting, in the etching process, such conditions as causing hydrogen plasma to damage the carbon film 2, the surface conductive film 9 consisting of an amorphous carbon film or preferably a carbon film containing an sp2 structure is formed on both the surface of the carbon film 2 and the surface of the acicular protrusion structure. Then, as shown in Fig. 7D, the insulator film 4 and the gate electrode 5 are selectively formed. The insulator film 4 consists of a metal thin film, to draw electrons from the carbon film 2. Although the acicular protrusion structure of the carbon film 2 has, in the present embodiment, such a shape that the carbon film 2 is left on the base, the acicular protrusion structure may be formed directly from the substrate electrode 1.

Next, the behavior of a field-emission type cold cathode according to the seventh of the present invention is described in detail with reference to Fig. 7D. To operate the field-emission type cold cathode device according to the seventh embodiment, a negative bias or a positive bias is applied to the tip of the substrate electrode 1 or the gate electrode 5 respectively. With this, an electric field is concentrated at the tip of the carbon film 2 the surface of which is rendered acicular protrusion-shaped and, at the same time, the surface of the acicular portion of the carbon film 2 is covered with the surface conductive film 9, so that electrons can be supplied from the substrate easily, making it possible to decrease the voltage to be applied to the substrate electrode 1 or the gate electrode 5.

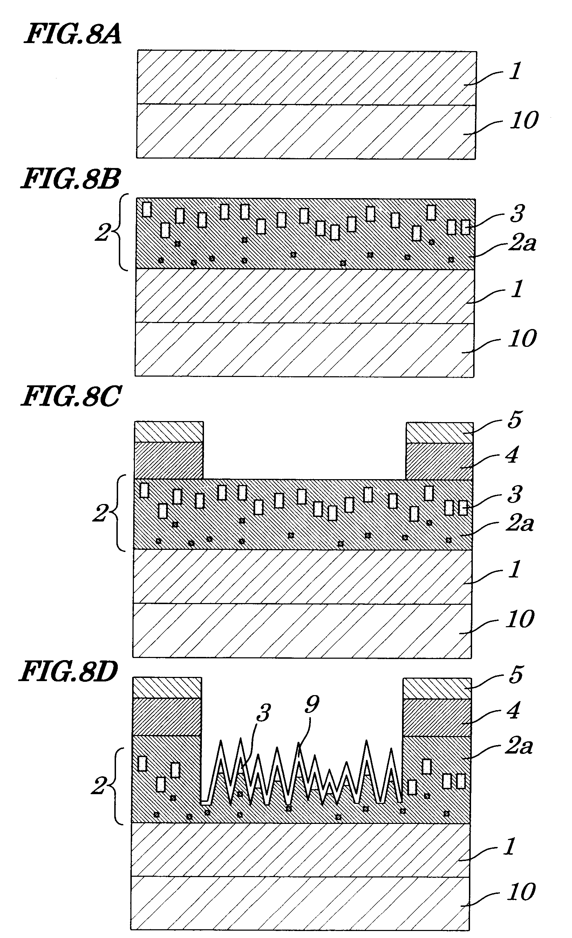

Next, an eighth embodiment of the present invention is described in detail with reference to the drawings. Fig. 8D is a cross-sectional view of a field-emission type cold cathode given in the eighth embodiment of the present invention. A substrate electrode 1, which constitutes a lower electrode, may be made of a semiconductor substance or any conductor such as for example Si, Mo, Fe, Ni, or Pt. A carbon film 2 which provides a cold cathode material is provided for emitting electrons. This carbon film 2 is a cathode material for emitting electrons, comprising an sp2-structured carbon 2a and an sp3-structured carbon 3. Also, this carbon film 2 has an acicular protrusion-structured surface. A surface conductive film 9 consists of a carbon film containing an sp2 structure, having high conductivity as compared to the carbon film 2 as well as a thickness of 10 nm or less and a surface resistivity of 10⁵Ωcm or less. Since the surface conductive film 9 is part of a path for supplying electrons, its resistivity is preferably low for example 10⁵Ωcm or less. Therefore, rather than an sp2-structured carbon film, an amorphous carbon film is preferably, and even more preferably a low-resistivity sp2-structured carbon film is employed. An insulator film 4, mainly formed with an oxide film etc., is an insulating material which electrically isolates the carbon film 2 and gate electrode 5. The gate electrode 5, which consists of a metal film, is provided to draw electrons from the carbon film 2. A support substrate 10 constitutes a base for the field-emission type cold cathode device, being made of such an insulating material as glass, plastic, or ceramic.

As shown in Fig. 8A, the support substrate 10 is made of glass, on which is deposited Mo using a sputtering method which provides the substrate electrode. Then, as shown in Fig. 8B, the carbon film 2 is formed on this substrate electrode 1 using a CVD or sputtering method. In the present embodiment, a diamond-like carbon film is formed as a cold cathode material on the substrate electrode 1, to a supposed thickness of 3 µm. As illustrated, the carbon film 2 has such a film construction that mixes therein sp2-structured carbon 2 and sp3-structured carbon 3. Then, as shown in Fig. 8C, an oxide film which provides the insulator film 4 and a metal film which provides the gate electrode 5 are deposited and then, an insulator film 4d and a gate electrode 5d are processed into an arbitrary shape by performing a lithographic step. Then, as shown in Fig. 8D, the surface of a cold cathode material 2d is exposed to hydrogen plasma. In this step of exposure, the sp3-structured carbon 3 acts as a mask to selectively etch the sp2-structured carbon 2a into an acicular protrusion structure. In this step of etching, by setting such conditions as causing hydrogen plasma to damage the carbon film 2, the surface conductive film 9 consisting of a carbon film which contains an sp2 structure is formed on the surface of the carbon film 2 and the surface of the acicular protrusion structure.

Next, the behavior of a field-emission type cold cathode device according to the eighth embodiment of the present invention is described in detail with reference to Fig. 8D as follows. To operate the field-emission type cold cathode device according to the present embodiment, a negative bias or a positive bias is applied to the substrate electrode 1 or the gate electrode 5 respectively. With this, an electric field is concentrated at the tip of the carbon film 2 the surface of which is rendered acicular protrusion-shaped and, at the same time, that acicular protrusion portion has reached the substrate electrode 1, so that electrons can be supplied from the substrate easily, thus making it easy to decrease the voltage to be applied to the substrate electrode 1d or the gate electrode 4d.

As mentioned above, a field-emission type cold cathode according to the present invention has such an effect that can easily achieve large emission-current properties even at a low voltage.

This is because a plurality of emitters each of which is formed with a carbon film is rendered sharp and acicular-shaped, thus intensifying a field strength applied at the emitter tip and forming a large number of emission points simultaneously.

Moreover, by using as an emitter material a carbon film which combines therein a diamond film with high emission performance, i.e. sp3-structured carbon film, and a graphite film with high conductivity, i.e. sp2-structured carbon film, it is possible to increase both the conductivity and the emission performance.

Furthermore, by arranging an sp3-structured carbon film at the tip of an emitter, the emitter performance can be improved even more.

Also, according to the present invention, it is possible to provide a method for manufacturing such a field-emission type cold cathode that can achieve large emission-current properties easily. This is because the carbon film can undergo plasma processing, to easily form a plurality of sharp and acicular emitters at the same time.

By, in particular, mixing a plurality of materials with different etching rates into a carbon film or on its surface during hydrogen plasma processing, the material with lower etching rate can act as a mask when the carbon film is being etched, thus forming acicular emitters in a self-alignment manner.

Still furthermore, by simultaneously forming an sp2-structured carbon film with a higher etching rate, during hydrogen plasma processing, and another carbon film with a lower etching rate when the carbon films are formed, it is possible to use the same film forming apparatus to form the carbon films and mask materials for forming emitters.

By, in particular, processing an sp3 structure or a carbon film containing an sp3 structure using hydrogen plasma, it is possible to carry out fine patterning of the surface of a cold cathode material without using photolithography.

This is because minute defects, impurities, or sp2-structured portions are selectively etched, thus causing an sp3-structured portion to act as a mask in the formation of an acicular structure.

Still furthermore, since carbon with an sp3 structure having large emission-current properties can be formed at the tip of an emitter in a self-alignment manner, the emitter performance can also be improved.

By, in particular, rendering the surface of an sp3 structure or a carbon film containing an sp3 structure acicular-structured, it is possible to achieve large current properties even with a low electric field.

This is because an effect of field concentration is enhanced by an acicular-structured surface of the cold cathode material.

Still furthermore, by performing ECR type hydrogen plasma processing, it is possible to obtain better plasma performance, thus easily forming sharp and acicular emitters.

Still furthermore, by, during formation of an acicular structure, covering the surface of the acicular structure with an amorphous carbon film or an sp2-structured film by damage by hydrogen plasma, a large current of electrons can be emitted.

This is because the sp2-structured film makes it easy to supply electrons to the tip of the acicular structure.

It is thus apparent that the present invention is not limited to the above embodiments but may be changed and modified without departing from the scope and spirit of the invention.

Finally, the present application claims the priority based on Japanese Patent Application No.Hei10-346538 filed on November 9, 1998, which is herein incorporated by reference.

## Claims

1. A carbon material characterized in that a surface of a carbon film (2) is covered with an acicular protrusion structure made of carbon.

2. A carbon material characterized in that a surface of a carbon film (2) consists of an acicular protrusion structure and a surface of said acicular structure is covered with an amorphous carbon film.

3. A carbon material characterized in that a surface of a carbon film (2) consists of an acicular protrusion structure and a surface of said acicular structure is covered with a conductive film (9) containing an sp2 structure.

4. A field-emission type cold cathode having a carbon material as claimed in one of claims 1 to 3, as an emitter.

5. The field-emission type cold cathode according to claim 4, characterized in that said carbon film (2) has a composite construction which combines an sp2 structure (2a) and an sp3 structure (3).

6. The field-emission type cold cathode according to either one of claims 4 or 5, characterized in that an sp3 structure (3) is formed at least below said carbon film (2).

7. Afield-emission type cold cathode characterized by having as an emitter an acicular protrusion structure made of carbon which is provided on a surface of a substrate electrode (1).

8. The field-emission type cold cathode according to any one of claims 4, 5 and 7, characterized in that at least a tip of said acicular protrusion structure consists of an sp3 structure.

9. The field-emission type cold cathode according to claim 8, characterized in that a radius of curvature of said sp3 structure is 1nm through 100nm.

10. The field-emission type cold cathode according to any one of claims 4 through 9, characterized in that said acicular protrusion structure has a shape of a cone or pyramid and a height of 10nm through 1µm.

11. The field-emission type cold cathode according to either one of claims 4 or 5, characterized in that a carbon material is used as an emitter.

12. The field-emission type cold cathode according to claim 11, characterized in that said carbon material is a diamond.

13. The field-emission type cold cathode according to claim 11, characterized in that said carbon material is diamond-like carbon.

14. The field-emission type cold cathode according to claim 11, 12 or 13 characterized in that an acicular structure of said carbon material reaches a lower substrate electrode (1).

15. The field-emission type cold cathode according to one of claims 11 to 14, characterized in that a thickness of said conductive film (9) is 10nm or less.

16. The field-emission type cold cathode according to claim 12, characterized in that a resistivity of said conductive film (9) is 10⁵Ωcm or less.

17. A method for manufacturing a carbon material characterized by comprising a step of performing plasma processing on a carbon film (2) in an atmosphere of hydrogen, to form an acicular carbon film on a surface of said carbon film (2).

18. The method for manufacturing a carbon material according to claim 17 characterized by comprising a step of performing plasma processing in an atmosphere of oxygen before or after said step of performing plasma processing in an atmosphere of hydrogen.

19. The method for manufacturing a carbon material according to either one of claims 17 or 18, characterized by comprising a step of etching said carbon film (2) during said plasma processing, to form an acicular carbon film.

20. The method for manufacturing a carbon material according to claim 19, characterized by comprising a step of forming a material with a different etching rate in or on a surface of said carbon film (2).

21. The method for manufacturing a carbon material according to claim 20, characterized by comprising a step of forming said carbon film (2) in such a way that said carbon film (2) may have an sp2 structure and an sp3 structure mixed therein.

22. The method for manufacturing a carbon material according to any one of claims 17 through 21, characterized in that said plasma processing is performed using ECR (Electron Cyclotron Resonance) plasma.

23. The method for manufacturing a carbon material according to claim 22, characterized in that said ECR plasma processing is performed with a bias being applied to a substrate in a processing apparatus.

24. A method for manufacturing a field-emission type cold cathode characterized by comprising a step of forming an acicular protrusion structure which provides an emitter, using said method for manufacturing a carbon material as claimed in any one of claims 17 through 21.

25. A method for manufacturing a field-emission type cold cathode characterized by comprising a step of providing a carbon film (2) on a substrate electrode (1) and performing plasma processing on said carbon film (2) in an atmosphere of hydrogen, to form an acicular carbon film on a surface of said substrate electrode (1).
